# EUROPEAN PATENT APPLICATION

(11) **EP 1 667 219 A1**
(43) Date of publication of application: **07.06.2006**
(21) Application number: 04772042.0
(22) Date of filing: 24.08.2004
(51) Int. Cl.: H01L 21/322

(54) **SILICON WAFER RECLAMATION METHOD AND RECLAIMED WAFER**

(30) Priority: 19.09.2003 JP 2003327704
(71) Applicant: Mimasu Semiconductor Industry Company Limited, Gunma-gun, Gunma 370-3531 (JP)
(72) Inventor: UCHIDA, T., c/o Mimasu Semiconductor Ind. Co., Ltd, Gunma-gun, Gunma 370-3533 (JP); IIJIMA, K., c/o Mimasu Semiconductor Ind. Co., Ltd, Gunma-gun, Gunma 370-3533 (JP); YAMAZAKI, T., c/o Mimasu Semiconductor Ind. Co Ltd, Gunma-gun, Gunma 370-3533 (JP); TOMARU, S., c/o Mimasu Semiconductor Ind. Co., Ltd, Gunma-gun, Gunma 370-3533 (JP); MARUYAMA, F., c/o Mimasu Semiconductor Ind. Co Ltd, Gunma-gun, Gunma 370-3533 (JP)
(74) Representative: McBride, Peter Hill
(86) International application number: PCT/JP2004/012081
(87) International publication number: WO 2005/029569

(57) **Abstract**

The present invention is a method for reclaiming a silicon wafer in which a thin film has been formed on its surface, at least, comprising a thin-film removing step for removing the thin film having been formed on the silicon wafer and a mirror-polishing step for mirror-polishing at least one side of the thin-film-removed silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced. Thereby, there is provided a method for reclaiming a silicon wafer, in which a thin film such as a metal thin film having been formed on a silicon wafer can be removed, and impurities having diffused inside the wafer can be also reduced, thereby silicon wafers having very little metal contamination can be stably obtained.

## Description

### Technical Field

The present invention relates to a method for reclaiming a silicon wafer used in steps for producing semiconductor devices and so forth to be in a usable state again, and particularly relates to a method for reclaiming a silicon wafer in which metal such as copper is used as a metal thin film for wiring.

### Background Technology

In a silicon wafer used in steps for producing semiconductor devices and so forth, an insulator film such as SiO₂ or a metal film for wiring such as Al, W, or Ti is generally deposited. For reclaiming such a silicon wafer as used in steps for producing devices and so forth, such a reclaiming method as immersing a silicon wafer in a chemical liquid such as a hydrofluoric acid or a sulfuric acid to dissolve and remove various types of thin films having deposited on the wafer, and then subjecting at least one side of front and back sides of the wafer to mirror-polishing has been conventionally used. However, in the case of reclaiming a silicon wafer by using such a method, there has been a risk that metal ions dissolved at a high concentration in the chemical liquid adhere to the wafer again during immersing the wafer and thereby re-contamination is caused.

However, in recent years, for meeting the tendency to speeding up of devices, copper wire is put into practical use as a wiring material having low resistance, and as silicon wafers used in steps for producing devices and so forth, wafers to which copper films adhere have increased. However, copper cannot be removed with such chemicals having been used conventionally as described above, and in the case that a wafer to which copper adheres is subjected to reclaiming treatment, there is possibility that the treatment process in itself is contaminated with copper and thereby other products are also contaminated with copper. Therefore, it has been thought that it is difficult to reclaim a silicon wafer to which a copper film has adhered.

Accordingly, for example, for solving the above problem and reclaiming a silicon wafer to which a copper film has adhered, a method for reclaiming a silicon single crystal wafer to which a copper film has adhered, at least, comprising a step of dissolving and removing a copper film with a sulfuric acid - hydrogen peroxide solution and a step of mirror-polishing the surface of the copper-film-removed wafer has been disclosed in Japanese Patent Application Laid-open (kokai) No. 2002-158207. It is possible to dissolve and remove a copper film easily and rapidly by using such a method and therefore it has become possible to reclaim a silicon wafer to which a copper film has adhered.

On the other hand, copper, gold, and such have a very fast rate of diffusion in silicon. Therefore, it is known that in such a case as copper having adhered to silicon, copper diffuses inside silicon in a short time. However, in the case of reclaiming a silicon wafer in which copper, gold or the like has diffused inside the wafer as described above, it is possible to remove copper having adhered to the wafer surface and to clean the wafer by using the above-described reclaiming method of Japanese Patent Application Laid-open (kokai) No. 2002-158207. However, in the case of copper (impurities) having diffused inside the wafer, it is impossible to remove it perfectly. Therefore, in such a case as leaving long hours the silicon wafer reclaimed by the method of Japanese Patent Application Laid-open (kokai) No. 2002-158207, impurities having diffused inside the wafer occasionally segregate out to the surface. Therefore, there is a problem that if the reclaimed polished wafer is subsequently used in steps for producing semiconductor devices and so forth, such troubles as lowering yield are caused.

### Disclosure of the Invention

Accordingly, the present invention has been made in view of the above problems. An object of the present invention is to provide a method for reclaiming a silicon wafer, in which a thin film such as a metal thin film having been formed on a silicon wafer is removed, and impurities having diffused inside the wafer are also reduced and thereby a silicon wafer having very little metal contamination can be stably obtained.

In order to accomplish the above object, according to the present invention, there is provided a method for reclaiming a silicon wafer in which a thin film has been formed on its surface, at least, comprising a thin-film removing step for removing the thin film having been formed on the silicon wafer and a mirror-polishing step for mirror-polishing at least one side of the thin-film-removed silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced.

By reclaiming a silicon wafer using such a method, a thin film such as a metal thin film having been formed on a silicon wafer can be removed, and impurities having diffused inside the wafer can be also reduced certainly through the use of gettering effect. Therefore, even such a contaminated silicon wafer as metal impurities having diffused inside the wafer after used in steps for producing semiconductor devices have become possible to be reclaimed easily, and extremely clean silicon wafers having very little metal contamination can be stably obtained.

In this case, it is preferable that the gettering-site forming treatment is performed by sandblasting or surface-grinding.

If the gettering-site forming treatment is performed by sandblasting or surface-grinding as described above, depth of damage load to be applied to the silicon wafer can be easily controlled and gettering sites can be formed easily and effectively in the wafer.

Moreover, it is preferable that in the thin-film removing step, the gettering-site forming treatment is also performed at the same time. In particular, if the thin-film removing step is performed by sandblasting or surface grinding, the gettering-site forming treatment can be also performed at the same time.

With regard to the present invention, in the thin-film removing step for removing a thin film having been formed on a silicon wafer, the gettering-site forming treatment can be also performed at the same time. For example, if the thin-film removing step is performed by sandblasting or surface-grinding, the gettering-site forming treatment can be also performed at the same time easily in the thin-film removing step. Therefore, gettering sites can be formed very effectively. In particular, if the thin-film removing step is performed by sandblasting, it becomes possible to remove a thin film by single treatment without changing polishing agents, independently of material of the thin film having been formed on the wafer. And at the same time, gettering sites can be formed in the thin-film-removed wafer surface.

In this case, it is preferable that the sandblasting is performed by using a dry blast apparatus.

If the sandblasting is performed by using a dry blast apparatus as described above, the sandblasting can be performed without wetting the silicon wafer. Therefore, polishing agents and polishing residue do not remain as contaminants on a wafer after sandblasting. Therefore, it becomes possible to prevent a silicon wafer from re-contamination certainly, and also it becomes possible to accomplish simplification of steps by omitting cleaning treatment of a silicon wafer and so on after the sandblasting treatment, thereby productive efficiency of reclaimed polished wafers can be drastically improved.

Furthermore, in the reclaiming method of the present invention, it is preferable that the heat treatment is performed at a temperature of 400°C to 700 °C. Moreover, it is preferable that in a cooling process of the heat treatment, the cooling rate is 4 °C/min or more.

By subjecting the gettering-site-formed wafer to the heat treatment at a temperature of 400°C to 700 °C as described above, impurities inside the wafer can be effectively precipitated in the gettering sites in a short time and be reduced. Furthermore, if the cooling rate is 4 °C/min or more in a cooling process of the heat treatment, precipitation effect of impurities in gettering sites can be more enhanced, thereby impurities inside the wafer can be significantly reduced.

Moreover, it is preferable that after performing the heat treatment, the silicon wafer is subjected to etching treatment before performing the mirror-polishing step.

By subjecting the heat-treated silicon wafer to etching treatment before performing the mirror-polishing step as described above, impurities precipitated in gettering sites can be dissolved and removed from the wafer. Therefore, it becomes possible to reduce reverse contamination risk in the mirror-polishing step, and silicon wafers of very high quality having very little metal contamination can be stably obtained.

Furthermore, in the present invention, the silicon wafer on which a metal film has been formed can be reclaimed. In particular, the silicon wafer that has been contaminated with metal impurities inside the wafer can be reclaimed.

As described above, the method for reclaiming a silicon wafer according to the present invention can be very suitably used in reclaiming a silicon wafer in which a metal film that is currently used as wiring material of semiconductor devices, such as copper thin film, has been formed. In particular, even a silicon wafer contaminated with metal impurities such as copper inside the wafer can be reclaimed by the reclaiming method of the present invention to be an extremely clean silicon wafer having very little metal contamination.

According to the present invention, a reclaimed polished wafer that is reclaimed by the above-described method for reclaiming a silicon wafer can be provided.

A reclaimed polished silicon wafer that is reclaimed by the reclaiming method of the present invention is a wafer having very little contamination with copper, particularly an extremely clean silicon wafer having a copper concentration of 1.0 x 10¹⁰ atoms/cm² or less in the wafer surface, even if, for example, the silicon wafer before reclaiming has a copper film or furthermore copper contamination is caused inside the wafer. Therefore, the reclaimed polished wafer of the present invention becomes a silicon wafer of very high quality without causing troubles such as lowering yield even if used in steps for producing semiconductor devices and so forth.

Moreover, according to the present invention, there can be provided a method for reclaiming a silicon wafer, at least, comprising a mirror-polishing step for mirror-polishing at least one side of the silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced.

By reclaiming a silicon wafer using such a method, impurities having diffused inside the wafer can be certainly reduced through the use of gettering effect. Therefore, for example, even such a contaminated silicon wafer as metal impurities having diffused inside the wafer used in steps for producing semiconductor devices and so forth, can be easily reclaimed and thereby extremely clean silicon wafers having very little metal contamination can be stably obtained.

As described above, according to the reclaiming method of the present invention, a thin film such as a metal thin film having been formed on the wafer surface can be easily removed and impurities having diffused inside the wafer can also be certainly reduced. Therefore, for example, even such a silicon wafer used in steps for producing semiconductor devices and so forth and having a metal film, or a silicon wafer in which impurities have diffused inside the wafer can be stably reclaimed to be an extremely clean silicon wafer having very little metal contamination.

### Brief Explanation of the Drawings

Fig. 1 is a flow chart showing an example of a method for reclaiming a silicon wafer according to the present invention.
Fig. 2 is a schematic constitutional view showing a constitution of a blast apparatus schematically.
Fig. 3 is a schematic constitutional view showing a constitution of a surface-grinding apparatus schematically.
Fig. 4 is a graph showing measurement results of a copper concentration in a silicon wafer after etching treatment and a copper concentration in a silicon wafer after mirror-polishing step in the Example.

### Best Mode for Carrying out the Invention

Hereinafter, embodiments according to the present invention will be explained. However, the present invention is not limited thereto.

The present inventors have carried out thorough experiments and studies with regard to a reclaiming method of a silicon wafer having a metal thin film such as a copper film used in steps for producing semiconductor devices and so forth, or particularly with regard to a method for reclaiming a silicon wafer where impurities such as copper have diffused inside the wafer, which is conventionally difficult to be reclaimed. As a result, it has been found that if a metal thin film that has been formed on a silicon wafer is removed, gettering sites are also formed in the silicon wafer and then the wafer is subjected to heat treatment, even a silicon wafer contaminated with metal inside the wafer can be stably reclaimed to be an extremely clean silicon wafer having very little metal contamination. Thus the present invention has been accomplished.

That is, a method for reclaiming a silicon wafer according to the present invention is a method for reclaiming a silicon wafer in which a thin film has been formed on its surface, at least, comprising a thin-film removing step for removing the thin film having been formed on the silicon wafer and a mirror-polishing step for mirror-polishing at least one side of the thin-film-removed silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced.

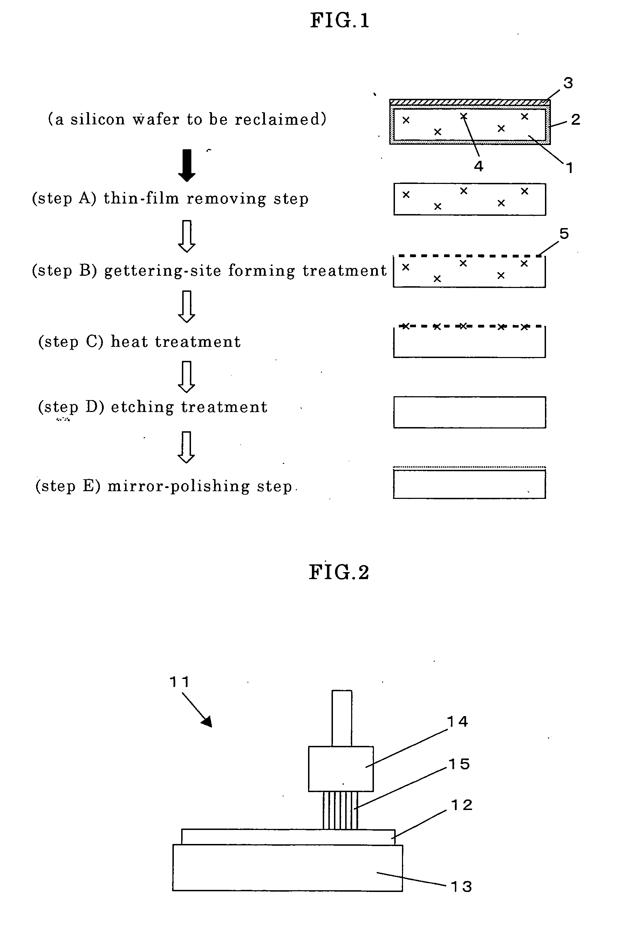

Hereinafter, a method for reclaiming a silicon wafer according to the present invention will be explained with reference to drawings. However, the present invention is not limited to this at all. Here, Fig. 1 is a flow chart showing an example of a reclaiming method according to the present invention.

A silicon wafer to be reclaimed in the present invention is, for example, a silicon wafer used in steps for producing semiconductor devices and so forth. In such a wafer, various types of insulator films such as SiO₂, a metal film for wiring such as Cu, Al, W, Ti, and Au, furthermore a copper-diffusion barrier film such as TaN for preventing copper from diffusing to silicon, or the like have been deposited. In addition, in an explanation of the present invention as presented as follows, as shown in Fig. 1, the case of reclaiming a silicon wafer 1 in which an insulator film 2 of SiO₂ and a copper film 3 are formed as the thin film on a wafer surface and furthermore copper 4 has diffused inside the wafer will be explained as an example.

First, in a method for reclaiming a silicon wafer according to the present invention, the copper film 3 and the insulator film 2 having been formed on the silicon wafer 1 in the thin-film removing step (step A in Fig. 1). In this case, a method for removing the copper film 3 and the insulator film 2 is not particularly limited. However, for example, the wafer 1 having been formed with the copper film 3 and the insulator film 2 is etched with a mixed solution of sulfuric acid and hydrogen peroxide solution and thereby the copper film 3 can be dissolved and removed. Then, the wafer 1 is etched with hydrofluoric acid or a mixed solution of hydrofluoric acid and hydrogen peroxide solution and thereby the insulator film 2 can be removed. By removing the copper film 3 and the insulator film 2 as described above, a surface of the silicon wafer 1 can be exposed.

Next, a gettering-site forming treatment for applying damage load to at least one side of the silicon wafer 1 and forming gettering sites in the wafer is performed (step B in Fig. 1). This gettering-site forming treatment can be performed by subjecting the silicon wafer to sandblasting using such a blast apparatus 11 as shown in Fig. 2. By this blast apparatus 11, a silicon wafer 12 is held at a wafer-holder 13, blast treatment is performed by spraying out a polishing agent 15 from a spray nozzle 14 connected with a polishing-agent supply tank (not shown) using a gas or a fluid (water) with high pressure, and thereby damage load can be applied to a surface of the silicon wafer 12. In this case, as the polishing agent 15, for example, alumina grains (Al₂O₃) with an average diameter of about 5-7 µm, silicon carbide grains (SiC), or the like can be used.

By using such a blast apparatus 11, at least one side of the above-described silicon wafer 1 whose surface has been exposed in the thin-film removing step, such as a surface of the wafer, is subjected to sandblasting. Thereby, as shown in Fig. 1, damage load is applied to the surface of the silicon wafer 1 and a strain layer 5 can be formed to be gettering sites.

Moreover, in the case of performing the gettering-site forming treatment by sandblasting as described above, it is preferable that the sandblasting is performed with a dry blast apparatus. If the sandblasting is performed using a dry blast apparatus as above described, the sandblasting can be performed without wetting the silicon wafer. Therefore, a polishing agent and polishing residue do not remain as contaminants on the wafer after the sandblasting. Therefore, re-contamination of the silicon wafer can be certainly prevented, and also such steps as a cleaning treatment of the silicon wafer after the sandblasting treatment can be omitted. Thereby, the number of steps can be reduced.

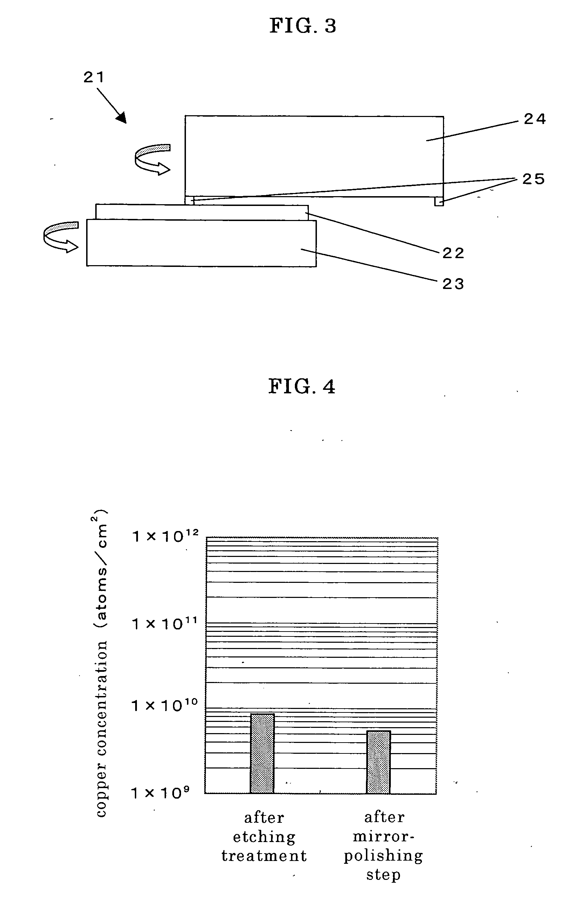

Furthermore, in the present invention, the gettering-site forming treatment can be also performed by subjecting the silicon wafer to surface-grinding using a surface-grinding apparatus 21 such as shown in Fig. 3. This surface-grinding apparatus 21 is an apparatus by which a surface of a silicon wafer 22 can be ground and at the same time damage load can be introduced in the ground wafer surface by rotating at a high speed a grind stone 25 bonded to a grinding turn table 24 while the silicon wafer 22 is held on a wafer-holding table 23 and is being rotated. In this case, as the grind stone 25, diamond grains with grain diameters of about 4-6 µm or fixed diamond grains with grain diameters of about 2-6 µm with an adhesive can be used.

As described above, in the gettering-site forming treatment, depth of damage load to be applied to the silicon wafer can be easily controlled by subjecting the exposed surface of the silicon wafer to sandblasting using the blast apparatus 11 or to surface-grinding using the surface-grinding apparatus 21. Thereby, gettering sites (a strain layer) for capturing impurities can be easily and effectively formed in a surface of the wafer.

After subjecting the silicon wafer to gettering-site forming treatment as described above, the obtained silicon wafer is subjected to heat treatment (step C in Fig. 1). By subjecting the silicon wafer 1 to heat treatment, copper 4 having diffused as impurities inside the silicon wafer can be precipitated in the gettering sites 5 in a short time. Thereby, copper existing inside the wafer can be reduced.

In this case, heat treatment conditions such as temperature, time, and atmosphere in the heat treatment is not particularly limited. However, for example, if the heat treatment temperature is so low in performing the heat treatment, it is thought that much time is required for precipitating impurities inside the wafer in the gettering sites. Moreover, on the other hand, if the heat treatment temperature is so high, it is thought that precipitation of impurities cannot be also performed effectively. Therefore, when the silicon wafer is subjected to the heat treatment, it is preferable that the temperature is 400 °C to 700 °C.

Furthermore, in this case, it is preferable that in a cooling process of the heat treatment, the cooling rate is 4 °C/min or more. If the cooling rate is 4 °C/min or more as described above, precipitation effect of impurities in gettering sites can be more enhanced and capture of impurities can be promoted. Therefore, impurities inside the wafer can be significantly reduced.

Next, by subjecting the heat-treated silicon wafer to etching treatment (step D in Fig. 1), the strain layer 5 having been formed in the surface of the silicon wafer 1 is removed and copper having been captured in the gettering sites is dissolved and removed with silicon. In this case, etchant used in the etching treatment is not particularly limited as long as being capable of etching a silicon wafer. For example, an alkaline etching solution such as KOH or NaOH, an acidic etching solution such as a mixed solution of HF and HNO₃ and so on can be used. In addition, in the present invention, the etching treatment is not indispensable to be performed. However, if the etching treatment is carried out before performing the mirror-polishing, a risk of reverse contamination and re-contamination in the subsequent latter steps of reclaiming (for example, a polishing step) can be certainly reduced.

Then, in the mirror-polishing step (step E in Fig. 1), by subjecting at least one side of the silicon wafer 1 to mirror-polishing, the wafer can be finished to a clean reclaimed polished wafer having an extremely low impurity concentration and very little metal contamination. In this case, the mirror-polishing may be carried out to at least one side of the wafer. For example, in the case of not performing the above-described etching treatment, impurities captured in the gettering sites can be removed by polishing.

In addition, this mirror-polishing step can be performed according to a method having been generally used. For example, after holding a silicon wafer with a surface to be processed down, the wafer is pressed against a turn table on which a polishing pad is attached, and the wafer is slid on the turn table by rotating the wafer and the turn table along with supplying a polishing agent on the polishing pad, thereby one side of the wafer can be subjected to the mirror-polishing.

Here, in order to investigate a removal effect of impurities having diffused inside the wafer when the gettering-site forming treatment to the etching treatment according to the present invention as described above (the step B to the step D in Fig. 1) are carried out, such experiments as presented as follows were performed. In the experiments, with regard to a silicon wafer that was purposely contaminated with copper, a copper concentration of the wafer that was subjected to the gettering-site forming treatment, the heat treatment, and the etching treatment in order, and a copper concentration of the wafer in which impurities were dissolved and removed only by etching conventionally were measured. And the concentrations were compared.

### (Experiment 1)

First, four silicon wafers with a 300-mm diameter were prepared. And, after immersing these silicon wafers in a mixed solution of sulfuric acid and hydrogen peroxide having a 1000-ppm copper concentration, the wafers were heated at 700 °C for 1 hour. Thereby, silicon wafers that were purposely contaminated with copper inside the wafers were prepared.

First, a wafer among the silicon wafers purposely contaminated with copper was subjected to sandblasting using the blast apparatus 11 as shown in Fig. 2 and thereby gettering sites were formed in the wafer surface. At this time, alumina grains with an average grain diameter of about 5 µm were used as a polishing agent. Next, the silicon wafer subjected to the gettering-site forming treatment was subjected to heat treatment by heating the wafer up to 650 °C and holding it for 1 hour and then cooling it down at a cooling rate of 4 °C/min . Then, the surface of the silicon wafer was etched and removed by 10 µm with a 48 % NaOH alkaline etching solution and dried. The surface layer of the obtained silicon wafer was dissolved by about 0.1 µm with a mixed solution of hydrofluoric acid and nitric acid. And by analyzing and measuring this dissolved solution with an atomic absorption spectrometer, a copper concentration of the silicon wafer was measured. As a result, it was found that the copper concentration of the wafer was 6.73 x 10⁹ atoms/cm².

### (Experiment 2)

Next, another silicon wafer purposely contaminated with copper as described above was subjected to surface-grinding using the surface-grinding apparatus 21 as shown in Fig. 3 and thereby gettering sites were formed in the wafer surface. At this time, as a grind stone, diamond grains in which those with grain diameters of about 2-6 µm having been fixed with resin were used. Then, after subjecting the silicon wafer to heat treatment and etching treatment as performed in the above-described Experiment 1, the copper concentration of the obtained silicon wafer was measured with the same method as above. As a result, it was found that the copper concentration of the wafer was 1.22 x 10¹⁰ atoms/cm².

### (Experiment 3)

For the comparison, another silicon wafer purposely contaminated with copper as described above was only etched by 10 µm with 48% NaOH, and the copper concentration of the obtained silicon wafer was measured by the same method to above. As a result, it was found that the copper concentration of the wafer was 2.01 x 10¹² atoms/cm². Furthermore, the other silicon wafer purposely contaminated with copper as prepared above was subjected to heat treatment at 650 °C for 1 hour, etched by 10 µm with 48% NaOH, and the copper concentration of the obtained silicon wafer was measured by the same method as above. As a result, it was found that the copper concentration of the wafer was 1.25 x 10¹² atoms/cm².

From the results of the Experiments 1-3, it can be confirmed that impurities inside a silicon wafer can be drastically reduced by subjecting the wafer to the gettering-site forming treatment and the heat treatment.

As described above, by a reclaiming method of the present invention, for example, a silicon wafer that was used in steps for producing semiconductor devices and so forth in which a thin film such as a metal thin film has been formed or metal impurities such as copper have diffused inside the wafer is reclaimed, thereby the thin film having been formed on the wafer surface can be easily removed and the metal impurities having diffused inside the wafer can be certainly reduced. Therefore, extremely clean silicon wafers having very little metal contamination can be stably obtained.

In particular, the present invention is effective in the case of reclaiming a silicon wafer contaminated with impurities having a fast rate of diffusion in silicon. Among them, the present invention is extremely effective for reclaiming a silicon wafer in which copper adheres to the wafer and copper contamination inside the wafer is also detected.

And a silicon wafer reclaimed by the reclaiming method of the present invention as described above can be an extremely clean silicon wafer, for example, having a copper concentration of 1.5 x 10¹⁰ atoms/cm² or less, particularly 1.0 x 10¹⁰ atoms/cm² or less. Conventionally, there have been disadvantages that reclaimed polished silicon wafers which are reclaimed from a wafer contaminated with copper are usable only in a copper wiring step. However, the reclaimed polished wafer reclaimed by the present invention has no risk of cross-contamination if used in various steps such as steps for producing semiconductor devices and so forth, and also becomes a silicon wafer of very high quality without causing problems such as lowering yield, thereby drastic cost reduction can be expected.

In addition, in the method for reclaiming a silicon wafer according to the present invention, the thin-film removing step for removing a thin-film such as a metal thin film having been formed on the silicon wafer surface (a step A in Fig. 1) can be performed by removing such a thin film by sandblasting using such a blast apparatus 11 as shown in Fig. 2 or by surface-grinding using the surface-grinding apparatus 21 as shown in Fig. 3. If the thin-film removing step is performed with sandblasting or surface-grinding, the gettering-site forming treatment can be also performed at the same time in the thin-film removing step. Therefore, gettering sites can be formed in a silicon wafer very efficiently.

In particular, if the thin-film removing step is performed with sandblasting, a metal thin film can be removed by single treatment without changing polishing agents, independently of material of the thin film having been formed on the wafer. And at the same time, gettering sites can be formed in the wafer surface that the metal thin film has been removed. Thereby, production efficiency of the reclaimed polished wafers can be considerably improved.

Furthermore, the method for reclaiming a silicon wafer according to the present invention is applicable to when a silicon wafer without a thin film on its surface is reclaimed. For example, by reclaiming a silicon wafer contaminated with metal impurities such as copper inside the wafer without a thin film on the wafer surface, impurities having diffused inside the wafer can be certainly reduced and thereby an extremely clean silicon wafer having very little metal contamination can be obtained.

Hereinafter, the present invention is explained in detail with reference to Example. However, the present invention is not limited thereto.

### (Example)

A silicon wafer with a 300 mm diameter which had been used in steps for producing devices and on which a copper-diffusion barrier film of TaN and a copper film had been deposited was reclaimed.

First, by performing the thin-film removing step with sandblasting using the blast apparatus 11 as shown in Fig. 2 to remove the copper-diffusion barrier film and the copper film having been deposited on the wafer surface and at the same time gettering sites were formed by applying damage load to the wafer surface. At this time, alumina grains with an average diameter of about 7 µm were used as the polishing agent. Next, the silicon wafer was subjected to heat treatment by heating the wafer up to 650 °C at a temperature rising rate of about 7 °C/min in an atmospheric air and holding it for 1 hour and then cooling it down at a cooling rate of 4 °C/min. Then, the surface of the silicon wafer was etched and removed by 10 µm with a 48 % NaOH alkaline etching solution.

After the etching treatment, the dried surface layer of the silicon wafer was dissolved by about 0.1 µm with a mixed solution of hydrofluoric acid and nitric acid. And by analyzing and measuring this dissolved solution with an atomic absorption spectrometer, a copper concentration of the silicon wafer was measured. As a result, it was found that the copper concentration of the wafer after the etching treatment was 8.55 x 10⁹ atoms/cm² as shown in Fig.4.

Moreover, the both sides of the silicon wafer subjected to the alkaline etching as described above were mirror-polished and then the wafer was cleaned to remove a polishing agent and so on adhering to the wafer. Then, as a result of measuring a copper concentration of the wafer with the same method as above, it was confirmed that the copper concentration after the mirror-polishing step was 5.47 x 10⁹ atoms/cm² as shown in Fig.4, and the wafer was an extremely clean reclaimed polished wafer.

In addition, the present invention is not limited to the embodiments described above. The above-described embodiments are merely examples, and those having the substantially same constitution as that described in the appended claims and providing the similar working effects are included in the scope of the present invention.

For example, in the above-described embodiments, the case of reclaiming a silicon wafer in which a copper film is formed on the wafer surface and copper has diffused inside the wafer was mainly explained as an example. However, the present invention is not limited thereto and can be applied to a case of reclaiming a silicon wafer on which at least one of other various metal films, or a case of reclaiming a silicon wafer contaminated with at least one of other various substances inside the wafer.

## Claims

1. A method for reclaiming a silicon wafer in which a thin film has been formed on its surface, at least, comprising a thin-film removing step for removing the thin film having been formed on the silicon wafer and a mirror-polishing step for mirror-polishing at least one side of the thin-film-removed silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced.

2. The method for reclaiming a silicon wafer according to Claim 1, wherein the gettering-site forming treatment is performed by sandblasting or surface-grinding.

3. The method for reclaiming a silicon wafer according to Claim 1 or 2, wherein in the thin-film removing step, the gettering-site forming treatment is also performed at the same time.

4. The method for reclaiming a silicon wafer according to Claim 3, wherein the thin-film removing step is performed by sandblasting or surface grinding, and thereby the gettering-site forming treatment is also performed at the same time.

5. The method for reclaiming a silicon wafer according to any one of Claims 2 to 4, wherein the sandblasting is performed by using a dry blast apparatus.

6. The method for reclaiming a silicon wafer according to any one of Claims 1 to 5, wherein the heat treatment is performed at a temperature of 400°C to 700 °C.

7. The method for reclaiming a silicon wafer according to any one of Claims 1 to 6, wherein in a cooling process of the heat treatment, the cooling rate is 4 °C/min or more.

8. The method for reclaiming a silicon wafer according to any one of Claims 1 to 7, wherein after performing the heat treatment, the silicon wafer is subjected to etching treatment before performing the mirror-polishing step.

9. The method for reclaiming a silicon wafer according to any one of Claims 1 to 8, wherein the silicon wafer on which a metal film has been formed is reclaimed.

10. The method for reclaiming a silicon wafer according to Claim 9, wherein the silicon wafer that has been contaminated with metal impurities inside the wafer is reclaimed.

11. A reclaimed polished wafer that is reclaimed by the method for reclaiming a silicon wafer according to any one of Claims 1 to 10.

12. A method for reclaiming a silicon wafer, at least, comprising a mirror-polishing step for mirror-polishing at least one side of the silicon wafer, wherein, before performing the mirror-polishing step, gettering-site forming treatment for applying damage load to at least one side of the silicon wafer is performed and then the silicon wafer is subjected to heat treatment, thereby impurities inside the silicon wafer are reduced.
